**Europäisches Patentamt**

**European Patent Office**

**Office européen des brevets**

(19)

(11) Veröffentlichungsnummer: **0 040 752**
**B1**

(12) # EUROPÄISCHE PATENTSCHRIFT

(45) Veröffentlichungstag der Patentschrift:
**12.09.84**

(51) Int. Cl.³: **H 05 K 7/02, H 01 R 13/631**

(21) Anmeldenummer: **81103651.6**

(22) Anmeldetag: **12.05.81**

(54) Galvanisch trennende Koppelstelle für Energie- und/oder Signalübertragung.

(30) Priorität: **22.05.80 DE 3019646**

(43) Veröffentlichungstag der Anmeldung:
**02.12.81 Patentblatt 81/48**

(45) Bekanntmachung des Hinweises auf die Patenterteilung:
**12.09.84 Patentblatt 84/37**

(84) Benannte Vertragsstaaten:
**DE FR GB NL SE**

(56) Entgegenhaltungen:
**DE - A - 2 524 845**
**DE - B - 1 276 684**
**DE - B - 2 434 890**
**FR - A - 2 274 147**
**US - A - 4 012 089**
**US - A - 4 038 625**

(73) Patentinhaber: **SIEMENS AKTIENGESELLSCHAFT,**
**Berlin und München Wittelsbacherplatz 2,**
**D-8000 München 2 (DE)**

(72) Erfinder: **Weller, Gerhard, Wacholderweg 13,**
**D-8520 Erlangen (DE)**
Erfinder: **Rosenfeldt, Bernd, Bunsenstrasse 33,**
**D-8520 Erlangen (DE)**
Erfinder: **Reis, Edmund, Richterstrasse 55,**
**D-8520 Erlangen (DE)**

## Beschreibung

Galvanisch trennende Koppelstelle für Energie- und/oder Signalübertragung.

Die Erfindung bezieht sich auf eine galvanisch trennende Koppelstelle für Energie- und/oder Signalübertragung, mit Primär- und Sekundärkoppelgliedern, von denen eines jeweils in einer Einbuchtung eines ersten Gehäuses sitzt, das als Steckteil in die Einbuchtung des ersten Gehäuses einschiebbar ist, wobei die Koppelglieder zueinander passende Ankoppelflächen aufweisen, über die durch Zusammenfügen bei Herstellen der Steckverbindung die Koppelstelle hergestellt wird.

Aus der Medizintechnik sind für Geräte zur Abnahme und Verarbeitung physiologischer Signale wie insbesondere EKG, Druck, Temperatur etc. Koppelstellen dieser Art z.B. aus dem DE-GM 77 36 156 (bzw. DE-PS 27 52 783) bekannt. Die GB-PS 13 83 577 beschreibt hingegen die Anwendung einer derartigen Koppelstelle an Schiffskörpern im Meereswasser, während die GB-PS 13 66 134 und GB-PS 14 47 469 Beispiele für Koppelstellen der allgemeinen Technik zeigen, bei denen zur Übertragung von Energie Spulen bzw. zur Übertragung von Signalen Lichtleiter als Primär- und Sekundärkoppelglieder verwendet werden. Bei allen diesen Koppelgliedern besteht nun der Wunsch nach möglichst hohem Wirkungsgrad der Ankoppelung. Dies gilt insbesondere auch für Koppelstellen gemäss DE-GM 77 36 156 (bzw. DE-PS 27 52 783) im Medizinbereich, an die besonders hohe Anforderungen hinsichtlich Spannungsfestigkeit und Isolation gerichtet werden. Hier besteht das Problem, dass die Trennstellen der Ankoppelung einerseits besonders spannungsfest und optimal isoliert sein müssen, während andererseits gewährleistet sein soll, dass eben an dieser Trennstelle Energie und/oder Signale mit möglichst geringen Verlusten übertragen werden.

Aufgabe vorliegender Erfindung ist es, eine Koppelstelle der eingangs genannten Art aufzubauen, die bei besonders hoher Spannungsfestigkeit und bei optimaler Isolation Energie- und/oder Signalübertragung mit optimal hohem Wirkungsgrad erlaubt.

Die Aufgabe wird erfindungsgemäss durch die im kennzeichnenden Teil des Patentanspruchs 1 angeführte konstruktive Ausgestaltung des Koppelgliedes gelöst.

Die schwimmende und federnde Aufhängung der Koppelglieder ermöglicht besonders intensiven Kontakt im Übertragungsweg an der Trennstelle der Übertragung zwischen den jeweils einander zugeordneten Koppelgliedern. Durch diese intensive Ankoppelung treten kaum Streuverluste auf; trotz optimaler Isolation an der Trennstelle ergibt sich also höchste Effektivität der Übertragung.

Im Falle von Koppelstellen, wo Energie und Signale übertragen werden, können sowohl die Koppelglieder für die Energieübertragung als auch die Koppelglieder für die Signalübertragung schwimmend und federnd aufgehängt sein. Im grossen und ganzen wird sich jedoch die schwimmende Aufhängung immer da empfehlen, wo die Koppelglieder relativ grosse Ankoppelflächen aufweisen. Hier kommt es aufgrund unvermeidbarer Fertigungstoleranzen immer wieder zu mehr oder weniger starken Fehlankoppelungen, sofern nicht dafür gesorgt wird, dass sich das jeweilige Koppelglied mit seiner Ankoppelfläche selbst die optimale Koppelverbindung sucht, was gemäss der Erfindung ja durch die schwimmende und federnde Aufhängung erreicht wird. Relativ grosse Ankoppelflächen weisen nun jedoch immer solche Koppelglieder auf, die zur Energieübertragung dienen. Aus diesem Grunde sollten also in vorteilhafter Ausgestaltung der Erfindung speziell das primäre und/oder zugeordnete sekundäre Übertragerhalbteil eines Energieübertragers immer schwimmend und federnd aufgehängt sein. Die Signalkoppelglieder, die im allgemeinen sehr viel kleinere Ankoppelflächen aufweisen und bei denen Verluste bei der Signalübertragung auch nicht so ins Gewicht fallen, wie Verluste bei der Energieübertragung, können durchaus auch im jeweiligen Gehäuse fest installiert sein; hierzu können die Gehäuse z.B. mit Nischen oder Einsätzen oder dergleichen zur Aufnahme der Lichtsender bzw. zugeordneten Lichtempfänger versehen sein.

Weitere Vorteile und Einzelheiten der Erfindung ergeben sich aus der nachfolgenden Beschreibung eines Ausführungsbeispiels anhand der Zeichnung in Verbindung mit den restlichen Unteransprüchen.

Es zeigen:

Figur 1 ein Gerät in Schrägansicht,
Figur 2 einen aus zwei Halbschalen aufzubauenden Isolierkörper,
Figur 3 den Isolierkörper mit montierter Rückplatte in teilgebrochener Ansicht,
Figur 4 eine Seitenansicht des Isolierkörpers mit einem Arretierhebelsystem für die Einschübe im Isolierkörper,
Figur 5 einen Einschub in Schrägansicht,
Figur 6 die Rückfläche eines Einschubes gemäss Figur 5,
Figur 7 einen Auswerfmechanismus für Einschübe an der Rückfläche des Isolierkörpers,
Figur 8 den inneren Aufbau eines Einschubes,
Figur 9 eine Koppelstelle für Energieankoppelung, teilweise im Schnitt.

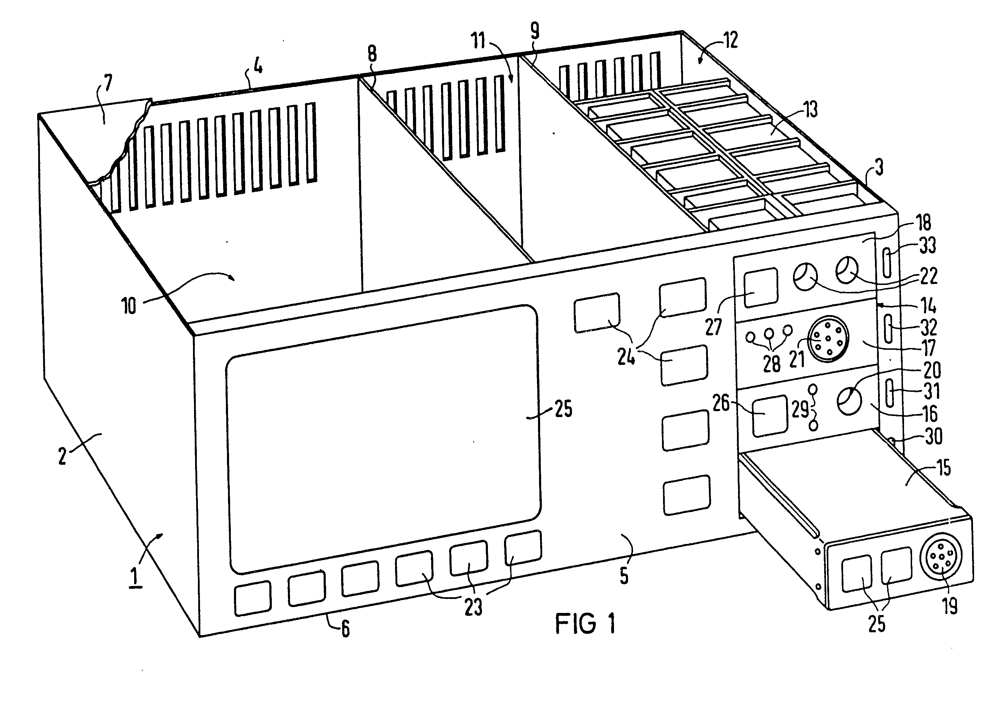

Die Figur 1 zeigt das Gerät mit einem im Zollmass aufgebauten Gerätegehäuse 1 mit den Seitenwänden 2 und 3, der Rückwand 4 und Frontfläche 5, der Grundfläche 6 sowie der nur gebrochen angedeuteten Deckfläche 7. Das Gerätegehäuse 1 ist durch z.B. zwei Zwischenwände 8, 9 in seinem Inneren in drei Kammern 10, 11 und 12 unterteilt. In der Kammer 10 sitzt beispielsweise eine (nicht dargestellte) Kathodenstrahlröhre zur Darstellung von Signalen. Die Kammer 11 nimmt z.B. Leiterplatten mit Bauelementen zur Signalverarbeitung bzw. Signalanzeige auf. Die Kammer 12 dient hingegen zur Aufnahme des Isolierkörpers 13, der als frontseitig offener Kasten ausgebildet ist, in dessen Inneren von der Frontöffnung 14 her insgesamt vier Geräteeinschübe 15, 16, 17 und 18 einschiebbar sind. Die Kammer 12 des Gerätegehäuses kann damit also z.B. als Einbuchtung definiert werden, die mit einem Isolierkörper 13 ausgekleidet ist, der wiederum zur Aufnahme von Einschüben dient. Ebensogut kann jedoch auch der Isolierkörper 13 selbst als Einbuchtung bezeichnet werden, die zur Aufnahme von Geräteeinschüben dient. Die Geräteeinschübe sind Bestandteil des Signalübertragungssystems. Sie können im Inneren schaltungsmässig so aufgebaut sein, wie beispielsweise im DE-GM 77 36 156 (bzw. DE-PS 27 52 783) ausführlich beschrieben ist. Wesentlich ist jedoch, dass jeder Einschub einen Mantel aus Isolationsmaterial hoher Spannungsfestigkeit aufweist, der in seinem Inneren neben den Leiterplatten mit Bauelementen und Metallabschirmung für diese Bauelemente auch noch die ersten Halbglieder einer Koppelstelle für Energie- und Signalübertragung trägt, während die dazu passenden zweiten Halbglieder speziell in der Rückfläche des Isolierkörpers 13 mit Verbindung zum freien Raum der Kammer 12 sitzen, wie im Detail später noch näher erläutert wird.

Das in der Figur 1 dargestellte Gerät ist speziell ein elektromedizinisches Gerät. Die Einschübe 15 bis 18 sind also Teil des Signalübertragungssystems für physiologische Signale, die mittels geeigneter Abnehmer am Körper eines Patienten abgenommen werden. Zu diesem Zweck werden also (nicht dargestellte) Abnehmer am Körper des Patienten positioniert und über ein Signalkabel (ebenfalls nicht dargestellt) am jeweiligen Einschub 15 bis 18 angekoppelt. Die Einschübe 15 bis 18 weisen zu diesem Zweck Steckbuchsen 19 bis 22 für die entsprechenden Stecker der Signalkabel auf. Selbstverständlich ist auch der Einsatz von Einschüben möglich, bei denen die Abnehmer über Signalkabel mit dem jeweiligen Einschub immer fest (also nicht in Steckverbindung) verbunden sind. Letzterer Fall bietet sich an, wenn das einzelne Einschubgehäuse relativ kleinvolumig ausgebildet ist. Der Einschub mit dem fest angeschlossenen Kabel ist dann selbst als Gerätestecker aufzufassen.

Im Ausführungsbeispiel der Figur 1 ist die Frontplatte 5 speziell als Folienplatte ausgebildet. Sämtliche Bedienungs- und/oder Anzeigeelemente liegen also in der Ebene der Folie, wie durch die Symbole 23, 24 angedeutet ist. Dasselbe gilt auch für das Bildfenster 25 für den Bildschirm der zu montierenden Kathodenstrahlrohre bzw. auch für die Frontflächen der eingeschobenen Einschübe 15 bis 18. Auch die Frontflächen der Einschübe liegen damit zusammen mit den ebenfalls nur schematisch dargestellten eingebauten Bedien- und Anzeigeelementen 25 bis 29 (28 und 29 sind z.B. Leuchtdioden) in der Folienebene der Frontplatte 5. Die Anordnung in einer Ebene verbietet das Anbringen von Griffen an den Einschüben, mit deren Hilfe eingesteckte Einschübe aus der Ausbuchtung des Gerätegehäuses wieder herausgezogen werden können. Um dennoch ein schnelles Auswechseln von Einschüben gewährleisten zu können, ist deshalb jeder Einschub speziell mit einem Auswerfmechanismus an der Rückwand des Isolierkörpers 13 versehen, der in Aktion tritt, wenn eine Arretiervorrichtung, die den Einschub im Hohlraum nach Einschieben arretiert, durch manuelle Betätigung einer am Gerätegehäuse angeordneten Ausklinktaste gelöst wird. Die einzelnen Ausklinktasten für die Einschübe sind in der Figur 1 an der äussersten rechten Kante der Frontplatte 5 mit den Kennziffern 30 bis 33 angedeutet. Weitere Details hinsichtlich Aufbau und Funktionsweise des Auswerfmechanismus in Verbindung mit der Arretiervorrichtung werden weiter unten beschrieben. In dem Ausführungsbeispiel der Figur 1 ist 15 beispielsweise ein $CO_2$-Einschub, 16 ein Einschub für Druckmessung, 17 ein Einschub für EKG-Messung und 18 ein Temperatureinschub. Selbstverständlich ist auch der Einsatz eines jeden anderen Einschubes für eine andere Messgrösse möglich.

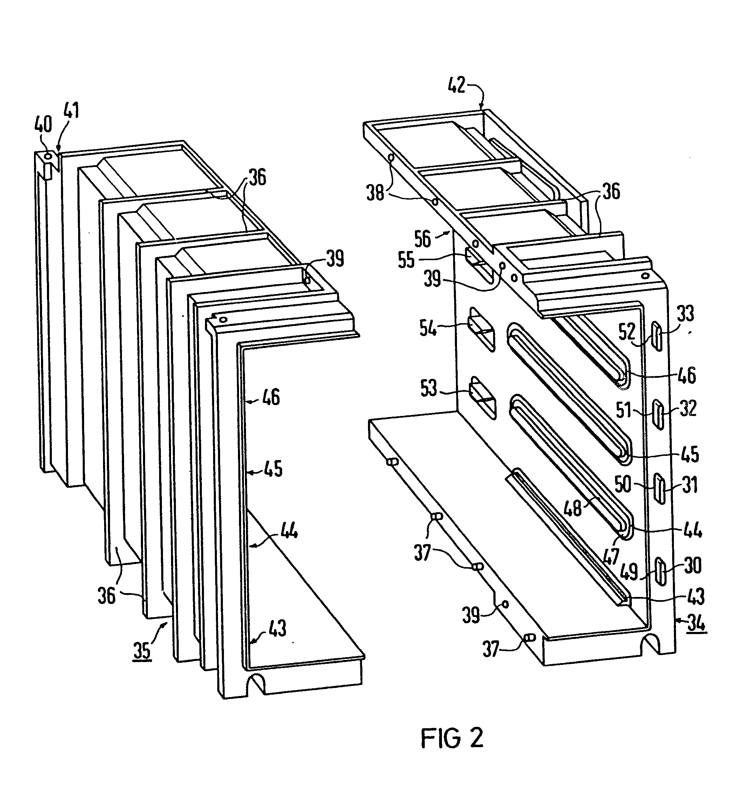

Gemäss der Figur 2 setzt sich der Umfang des Isolierkörpers 13 aus zwei Halbschalen 34 und 35 zusammen. Beide Halbschalen sind aus dem Kunststoff Amino-Butadien-Styrol (ABS) gefertigt, der sich leicht formen lässt und zudem auch relativ preisgünstig ist. Um bei relativ grosser Aussenfläche des Isolierkörpers mit möglichst wenig Isoliermaterial auskommen zu können, sind die beiden Halbschalen 34 und 35 speziell als Rippenkörper geformt. Jede der Schalen 34 und 35 umfasst also an ihrem Umfang Rippen 36, die die Innenwandung des Isolierkörpers unter Einschluss von Isolierschichten aus Luft zwischen den Rippen in vorgebbarem Abstand von den Metallwänden der Gehäusekammer 12 halten. Im vorliegenden Fall beträgt die Tiefe der Rillen insbesondere an den Seitenwänden der Halbschalen ca. 7 mm. An den Ober- und Unterflächen der Halbschalen sinkt die Tiefe aus montagetechnischen Gründen auf einen Wert bis etwa 3 mm. Die Dicke der Rippen beträgt ca. 1,5 mm. Die Materialbreite der Innenwandung der Halbschalen beträgt ca. 3 mm. Der aus beiden Halbschalen 34 und 35 zusammengesetzte Isolierkörper besitzt eine Aussenbreite von 2/8″ (ca. 0,0063 m), von Aussenrippen zu Aussenrippen gemessen. Die Höhe des kastenförmigen Isolierteils liegt bei ca. 180 mm (entsprechend vier Höheneinheiten HE). Diese Bemessung des Rippenkörpers 13 und die Auswahl des entsprechenden isolierenden Kunststoffes führen im vorliegenden Ausführungsbeispiel dazu, dass die Kapazität zwischen Metallteilen innerhalb des Gehäuses der Einschübe 15 bis 18 und Metallteilen ausserhalb des Isolierkörpers 13 (Abschirmwände der Kammer 12 des Gerätegehäuses bzw. an der Rückwand des Isolierkörpers 13 befindliche Metallteile), bezogen auf eine Betriebsspannung von 220 V und 50 Hz, auf einen Wert < 130 pF begrenzt wird. Bei dieser Kapazität ist ein möglicherweise gliessender Arbeitsstrom ungefährlich niedrig (< 10μA).

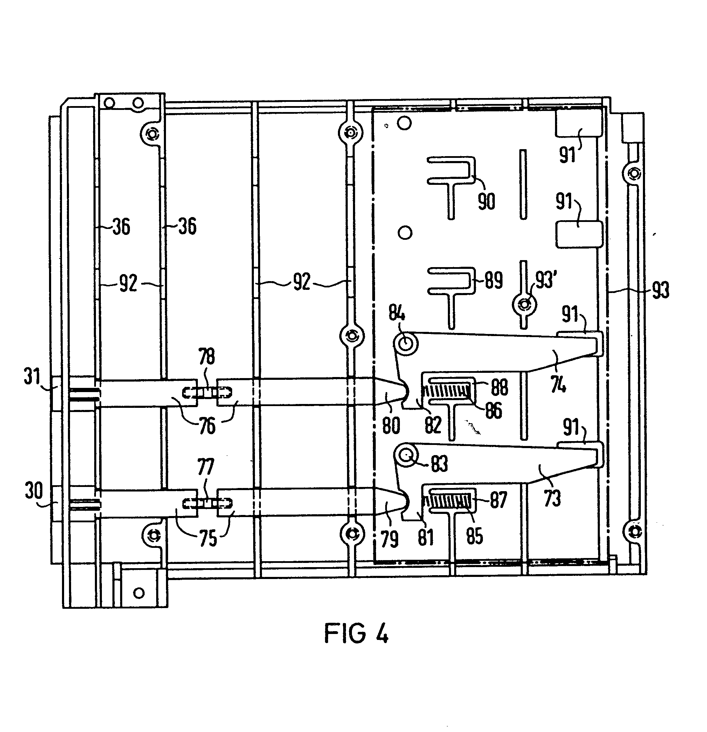

In der Figur 2 umfassen die beiden Halbschalen 34 und 35 des Isolierkörpers an den einander zugewandten Montierkanten Bolzen 37 an jeweils einer Montierkante des einen Halbteiles, die zu entsprechenden Justierlöchern 38 an der Gegenkante des anderen Halbteiles passen. Nach Zusammenfügen der beiden Halbschalen 34 und 35 werden diese an den Aneinandersetzleisten frontseitig über Schraublöcher 39 auf der Deckseite und entspechende Schraublöcher 39 auf der Grundseite mit je einer Schraube miteinander verschraubt. Entsprechendes gilt für zwei Eckschraublöcher 40 im hinteren Teil der Deckfläche der Halbschalen, die über entsprechende Ecklöcher an der Oberkante einer ansetzbaren Rückwand mit der Rückwand verschraubbar sind. Die Unterflächen der beiden Halbschalen werden hingegen rückseitig durch eine spezielle Ausformung der Rückwand zusammengepresst, die in zwei Nuten 41, 42 an den rückseitigen Längskanten der zusammengesetzten Halbschalen 34 und 35 einschiebbar ist. Bei eingeschobener Rückwand bildet dann der aus den beiden Halbschalen zusammengesetzte Isolierkörper 13 einen frontseitig offenen Kasten, in den die Einschübe eingeschoben werden können. Zum etagenmässigen Einschieben der einzelnen Einschübe 15 bis 18 haben die beiden Halbschalen an ihrer Innenwandung Längsschienen 43 bis 46. Diese Längsschienen sind so geformt, dass auf eine relativ flache Wandauswölbung 47 ein stärker ausgewölbter Längssteg 48 (dargestellt am Beispiel der Schiene 44) folgt. Dies hat zum Ergebnis, dass der einzuschiebende Einschub, getragen vom jeweiligen Steg 48 einer Führungsschiene 43 bis 46, nur auf der leichten Auswölbung 47, d.h. nicht mit der gesamten Seitenfläche an der Innenwand des Isolierkörpers, gleitet. Hierdurch ergibt sich eine besonders reibarme Bedienweise des Einschubes. Die Stegauswölbungen sind leicht abgerundet; der ausgewölbte Mittelsteg 48 passt zu einer entsprechenden Gleitrille an den Längskanten eines jeden Einschubes. Gleitstege 43 bis 46 und Längsrillen an den Einschüben sorgen aufgrund ihrer Abgerundetheit nicht nur für reibarmes Gleiten; die abgerundeten Stege und Gleitrillen vermeiden auch scharfe Kanten, an denen sich leicht Schmutz ansetzt. Diese Art von Gleitlagerung ist also auch nach Gesichtspunkten der Reinlichkeit optimal ausgelegt. In der Figur 2 sind schliesslich an der rechten Aussenkante der Halbschale 34 die Ausklinktasten für das Arretierhebelsystem wieder mit 30 bis 33 angedeutet. Die Tasten 30 bis 33 ragen dabei nur um einen solchen Wegbetrag aus Öffnungen 49 bis 52 der Kante der Halbschale 34 hervor, dass nach Montage des Isolierkörpers in der Kammer 12 des Gerätegehäuses 1 bei Abdeckung der Frontfläche 5 mit der Folie die Stirnfläche jeder Klinktaste in etwa in der Ebene der Abdeckfolie der Frontplatte 5 liegt. Die Betätigung einer Ausklinktaste 30 bis 33 erfolgt dann durch Druck auf die Folie an der Stelle der Ausklinktaste. Das Drücken einer Ausklinktaste 30 bis 33 bewirkt, dass speziell im vorliegenden Fall über ein Hebelsystem ein Kinkhebel betätigt wird. Die Arretiernasen der jeweiligen Klinkhebel, die im eingeschobenen Zustand des Einschubes in eine Nut an einer Seitenkante des Einschubes eingreifen, sind in der Figur 2 an der hinteren Innenseite der rechten Halbschale mit 53 bis 56 angedeutet. Nähere Einzelheiten über Aufbau und Funktionsweise der Arretiervorrichtung ergeben sich aus der noch folgenden Beschreibung zur Figur 4.

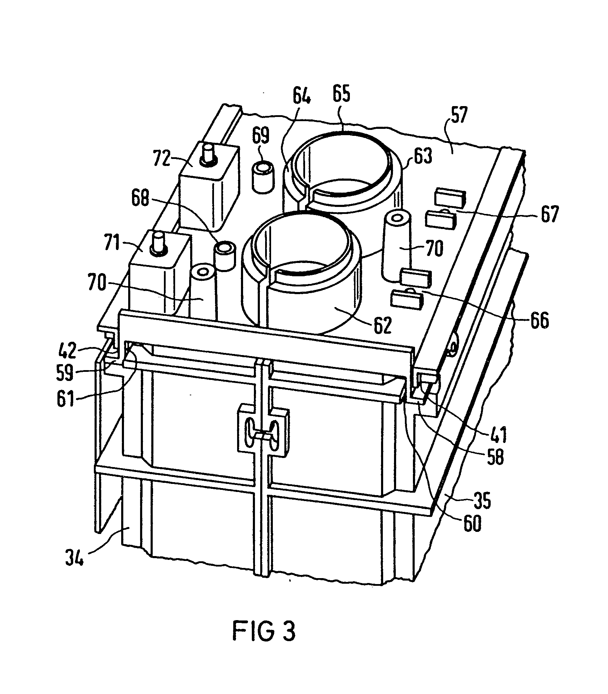

Die Figur 3 zeigt in teilweise gebrochener Ansicht die zum Ganzkörper zusammengefügten Halbschalen 34 und 35 schräg von unter und gegenüber der Darstellung der Figur 2 um ca. 180°C gedreht. Mit eingezeichnet ist jetzt die in die Nuten 41 und 42 eingeschobene Rückplatte 57. Die Nutstege 58 und 59 dieser Rückplatte gleiten am untersten Ende kurz vor vollständigem Einschieben der Platte über zwei leicht geschrägte Flächen 60 und 61 an der hinteren Unterkante der Unterflächen der beiden Halbschalen 34 und 35. Die Nutstege üben damit an ihren Unterkanten über die zunehmende Schrägfläche 60 bzw. 61 Druck auf die Unterseiten der beiden Halbschalen aus. Die beiden Halbschalen werden an dieser Stelle zusammengedrückt und haften damit gut aneinander. Die Rückplatte 57 besteht ebenfalls aus Kunststoff, vorzugsweise wieder ABS. Sie ist nicht nur rückwärtiges Abschlussteil des Isolierkörpers 13; vielmehr dient die Rückplatte 57 auch als Träger jener Teilglieder der Koppelstelle, die als geräteseitige Halbteile zu den Halbteilen im Inneren der Einschübe passen. In der Figur 3 weist also die Rückplatte insgesamt vier Aufnahmezylinder für Koppelglieder zur Energieübertragung auf, von denen allerdings wegen der teilgebrochenen Darstellung nur zwei zu sehen sind, die mit 62 und 63 bezeichnet sind. Der obere, der Rückplatte 57 abgewandte Rand eines jeden Montagezylinders 62, 63 etc. ist stegartig verdünnt. Die Schulter 64 der Stegverdünnung des Oberrandes dient dabei als Auflage für eine Montageplatte, die durch den eigentlichen Oberrand-Rundsteg 65 zentriert wird. Die Montageplatte ist wiederum Träger der Koppelglieder in schwimmender Aufhängung; sie selbst sitzt auf einer Leiterplatte, auf der die für die Energieübertragung bzw. Signalübertragung erforderlichen elektronischen Bauelemente montiert sind. Im vorliegenden Falle erfolgt die Signalübertragung vom Einschub Richtung Signalverarbeitungsteile des Gerätes mittels Lumineszenzdioden vorzugsweise im Infrarotbereich. Zu diesem Zweck sind für insgesamt vier Sendedioden, die als primäre Signalkoppelglieder im jeweiligen Einschub 15 bis 18 angeordnet sind, auf der Rückplatte 57 vier geräteseitige Lichtempfänger (z.B. Fotodioden) als sekundäre Signalkoppelglieder vorgesehen. Die Montagenischen für die Lichtempfänger sind auf der Montageplatte 57 mit den Kennziffern 66, 67 etc. angedeutet. Entsprechend sind auch für Signalübertragung (Schal- oder sonstige Steuersignale) vom Inneren des Gerätegehäuses in Richtung Einschübe auf der Rückplatte 57 des Isolierkörpers Einsätze 68, 69 etc. Für Sendedioden vorgesehen. Die dort einzusetzenden Lumineszenzdioden sind dann die primären Koppelglieder für einen Sendefall; die zugeordneten Empfänger sitzen als sekundäre Koppelglieder innerhalb des Einschubgehäuses. Wird also ein Einschub 15 bis 18 in eine Etage des Isoliergehäuses 13 bis in seine Endstellung eingeschoben, so ergibt sich automatisch Koppelverbindung zwischen Koppelgliedern für Energieübertragung vom Gerät zum Einschub und Koppelgliedern für Signalübertragung sowohl vom Einschub in Richtung Gerätegehäuse als auch vom Gerätegehäuse in Richtung Einschub. Im Ausführungsbeispiel der Figur 3 umfasst darüber hinaus die Rückplatte 57 noch Schraubfüsse 70 zum Festschrauben der die Montageplatte tragenden Leiterplatte, und an der linken Seite der Platte 57 sind die ersten beiden Auswerfer 71 und 72 von insgesamt vier Auswerfern für je einen Einschub zu sehen.

Die Figur 4 zeigt, wie schon vorstehend angedeutet, die, von der Öffnung her gesehen, rechte Seitenwand des Isolierkörpers 13, an der das Hebelsystem für die Arretierung der einzelnen Einschübe 15 bis 18 montiert ist. Dieses Hebelsystem umfasst dabei für jeden Einschub einen Klinkhebel 73, 74 etc. mit den in der Figur 2 dargestellten Arretiernasen 53 bis 56. Jedem Klinkhebel 73, 74 etc. ist ein Betätigungshebel 75, 76 etc. zugeordnet, der bei Druck auf die endständige Ausklinktaste 30, 31 etc. ausgelenkt wird und den Klinkhebel betätigt. Jeder Auslenkhebel 75, 76 etc. besteht dabei aus zwei Teilen, die durch je eine Justierschraube 77, 78 etc. auf eine gewünschte Gesamtlänge des Hebels einjustierbar sind. Jeder Auslenkhebel 75, 76 etc. stösst darüber hinaus über ein zugespitztes Ende 79, 80 etc. in eine Mulde des der Arretiernase abgewandten, um etwa 90° abgekröpften Endes des Klinkhebels 73, 74 etc. Bei Druck auf diese Mulde wird demnach der Hebel um sein Drehgelenk 83, 84 etc. gegen den Druck einer Feder 85, 86 etc., die in einer Nische 87, 88, 89, 90 der Seitenwand gelagert ist, einwärts geschwenkt. Diese Einwärtsschwenkung des einen Hebelendes führt zu einer Aufwärtsschwenkung des anderen Hebelendes mit der Arretiernase 53 bis 56. Die durch die Seitenwandöffnung 91 in das Innere des Isolierkörpers greifende Arretiernase 53 bis 56 wird nach oben angehoben. Die Arretiernase springt aus der entsprechenden Arretiernut des Einschubes und der Einschub wird im selben Augenblick durch den Auswerfmechanismus aus dem Isoliergehäuse ausgeworfen. Bei der Arretiervorrichtung der Figur 4 sind die Längshebel 75, 76 etc. in Nischen 92 der Rippen der Seitenwand eingelagert. Zur Sicherung der Klinkhebel 73, 74 nebst Federn 85, 86 gegen Herausspringen aus ihren Halterungen dient eine (strichpunktiert dargestellte) Kunststoffplatte 93, die in einem Schraubloch 93' an der Seitenwand des Isoliergehäuses über den Hebeln und Federn angeschraubt wird.

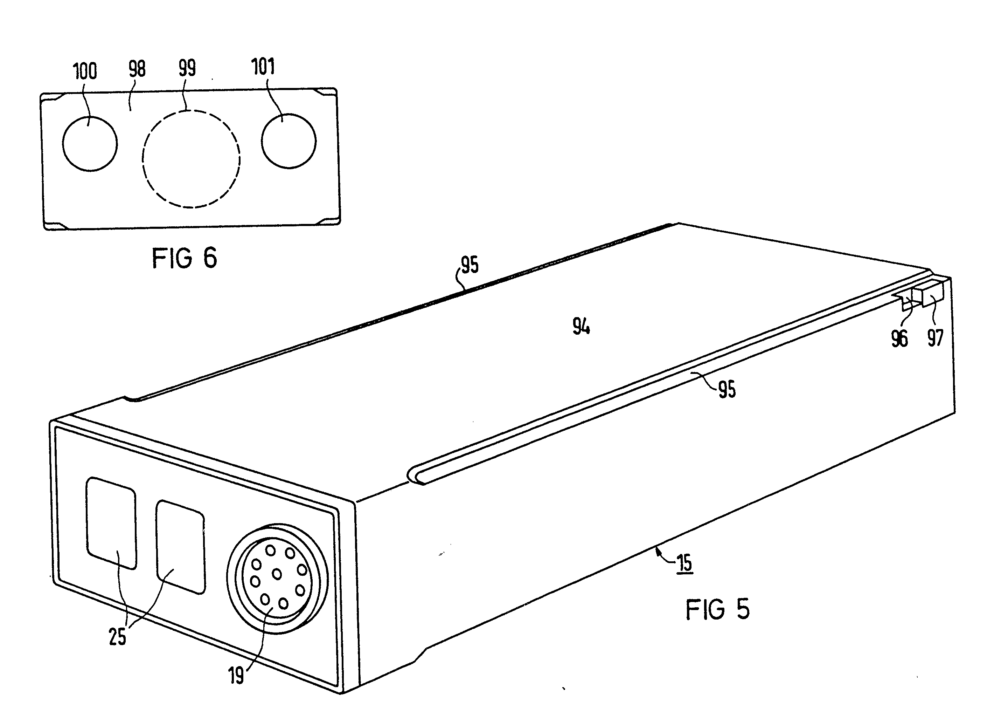

Die Figur 5 zeigt das Ausführungsbeispiel eines Einschubes, beispielsweise des Einschubes 15 in der Figur 1. Jeder der Einschübe umfasst ein nur frontseitig offenes Mantelgehäuse 94 aus hochisolierendem Kunststoff, z.B. wieder ABS. Der hochisolierende Mantel 94 ist entlang seinen Längskanten mit den schon erwähnten wohlgerundeten und deshalb auch leicht zu säubernden Gleitrinnen 95 versehen. Am hinteren Ende der rechten oberen Kante des Einschubmantels 94 befindet sich die Klinknut 96, in die ein Block 97 aus hartem Kunststoff, insbesondere Polyamid-Glasfaser, eingeklebt ist. Der harte Block 97 schützt die Einklinknut 96 gegen allzu starke Beanspruchung durch die Arretiernase des Klinkhebels. Die Frontöffnung des Mantelgehäuses 94 eines jeden Einschubes ist mit einer Einschubfrontplatte dicht abgeschlossen. Die Figur 6 zeigt die Rückwand 98 des Mantelgehäuses 94. Diese Rückwand ist im Zentrum 99 (gestrichelt angedeutet) im Material scheibenartig verdünnt. Die Verdünnung an dieser Stelle gewährleistet eine besonders enge Ankoppelung des dahinterliegenden Übertragerkörpers auf der Seite des Einschubes an jenen auf der Seite des Gerätes an der Rückplatte des Isolierkörpers in der Endstellung des Einschubes. Mit 100 und 101 sind zwei Fenster für das Infrarotlicht der beiden Signalübertragungskoppler eines jeden Einschubes angedeutet. Bei dem Fenster handelt es sich um rot eingespritzten Kunststoff oder um ein echtes Infrarotfilter. Die beiden Fenster sind wasser- und luftdicht sowie hochspannungsfest durch Ultraschall in die Rückwand 98 eingeschallt.

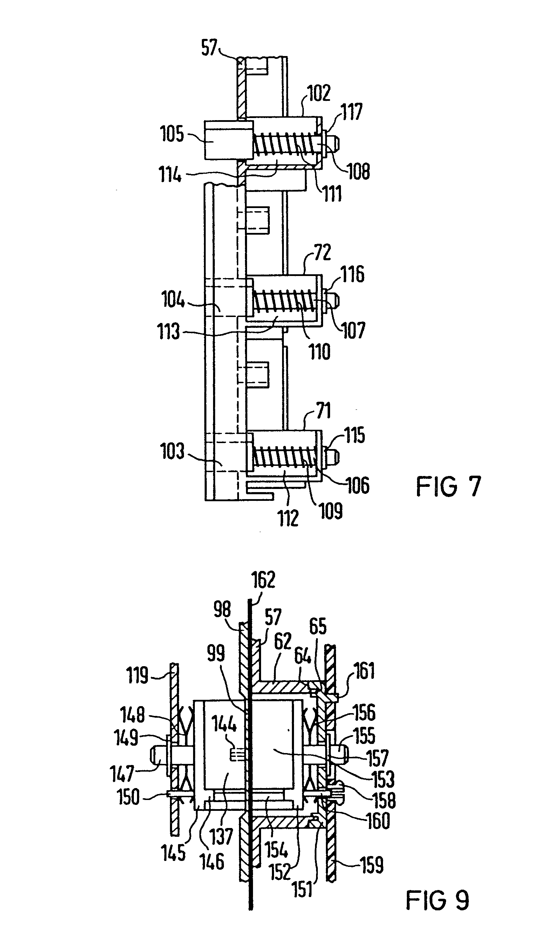

Die Figur 7 zeigt im Detail den Auswerfmechanismus an der Rückplatte 57 des Isolierkörpers. Zusätzlich zu den Auswerfblöcken 71, 72 der Figur 3 ist noch ein dritter Auswerfblock 102 dargestellt. Ein vierter Auswerfblock ist wegen der gebrochenen Darstellung nicht mehr mit eingezeichnet. Jeder Block 71, 72, 102 etc. umfasst ein Stossglied 103, 104, 105 etc. Jedes dieser Stossglieder ist mit einem Stössel 106, 107, 108 etc. verbunden, der durch eine Schraubenfeder 109, 110, 111 etc. im Innenraum 112, 113, 114 etc. der jeweiligen Auswerfblöcke federnd gehaltert ist. Zur äusseren Sicherung der Stössel dienen Sicherungsringe 115, 116, 117 etc. Wird also ein Einschub in die ihm zugeordnete Etage des Isoliergehäuses 13 eingeschoben, so wird durch die Rückwand des Einschubes das sich in Höhe dieser Etage befindende Stossglied 103 bis 105 samt Stössel 106 bis 108 etc. gegen den Druck der den Stössel umgreifenden Feder 109 bis 111 nach hinten geschoben. Der in seiner Endstellung schliesslich durch die Arretiernase 53 bis 56 des Klinkhebels 73, 74 etc. in seiner Rastnut 96 festgehaltene Einschub drückt nun so lange auf das Stossglied 103 bis 105 etc., bis durch Druck auf die zugehörige Ausklinktaste 30 bis 33 des Arretierhebelsystems die Arretierung durch den Klinkhebel gelöst wird. Die Federkraft der gespannten Feder 109 bis 111 sorgt dann dafür, dass der Einschub durch das Ausstossglied 103 bis 105 aus dem Inneren des Isolierkörpers zumindest so weit herausgestossen wird, dass er an seiner Frontseite von Hand bequem ergriffen und herausgezogen werden kann. Jeder Stössel betätigt in bevorzugter Ausbildung auch noch einen Schalter, insbesondere Mikroschalter, in dem Sinne, dass mit Auswerfen eines Einschubes die Stromzufuhr zum Primärübertrager auf der Geräteseite unterbrochen wird.

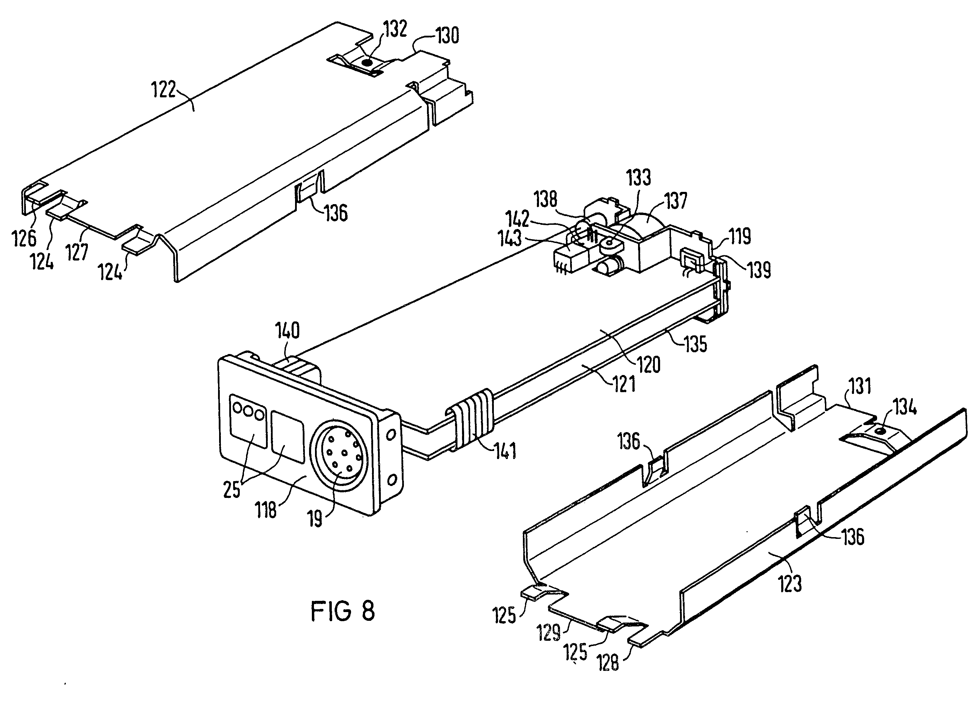

Die Figur 8 zeigt als Ausführungsbeispiel den inneren Aufbau eines Einschubes 15 bis 18. Dieser innere Aufbau ist dadurch gekennzeichnet, dass zwischen dem Frontteil 118 des Einschubes und einem Rückteil 119 nach Art einer Steckverbindung insgesamt zwei Leiterplatten 120 und 121 gehaltert sind. Auf diesen Leiterplatten sind die wesentlichen elektronischen Bauelemente für Energie- und Signalübertragung montiert. Dieser Teilaufbau aus Front- und Rückfläche sowie Leiterplatten ist schliesslich nach Sandwich-Art durch zwei metallische Abschirmbleche 122 und 123 (z.B. aus Aluminium oder Stahlblech) abgedeckt. Beide Abschirmbleche 122 und 123 sind an der Vorderkante mit Klauen 124 bzw. 125 versehen. Bei Auflage des jeweiligen Bleches mit den ebenen Kanten 126, 127 bzw. 128, 129 auf die Innenschulter der Frontplatte 118 greifen die Klauen 124 bzw. 125 in Ausnehmungen unterhalb der Schulter, so dass sich an der Schulter eine Art Klemmverbindung zur Halterung der Vorderkante der beiden Bleche 122 und 123 ergibt. Die Rückkanten 130 bzw. 131 der Bleche 122 und 123 liegen hingegen auf den Kanten des Rückteils 119 auf. Sie werden über Schraublöcher 132, 133 bzw. 134, 135 mit dem Rückteil verschraubt. Die mittleren Teile der Abschirmbleche 122, 123 liegen über Klauen 136 federnd an den Seitenkanten der Leiterplatten 120 und 121 an. Im Ausführungsbeispiel der Figur 8 ist das Rückteil 119 zum Zwecke der Abschirmung aus metallisiertem Kunststoff gefertigt. Das Rückteil 119 ist gleichzeitig Träger von Koppelgliedern zur Energie- und Signalübertragung. So trägt es u.a. in schwimmender Aufhängung einen Schalenkern zur Aufnahme eines Spulenkörpers als Sekundärteil eines Koppelgliedes für Energieübertragung vom Gerät zum Einschub. Zur Signalübertragung vom Einschub zum Gerät sind an der linken Seite ein Einsatz für eine Sendediode 138 (Lumineszenzdiode) und zur Signalübertragung vom Gerät zum Einschub auf der rechten Seite eine Nische für einen Lichtempfänger 139 (Fotodiode) angeordnet. Zur leitungsmässigen Verbindung zwischen Vorderplatte 118 (Folienfrontplatte mit integrierten Schaltern) des Einschubes und Leiterplatten 120, 121 dient ein Signalkabelstrang 140, während zur Verbindung der Leiterplatten untereinander ein Signalkabelstrang 141 vorgesehen ist. Zur Herstellung einer Leitungsverbindung für die Energieübertragung vom im Schalenkern 137 sitzenden Spulenkörper zum zugehörigen Schaltungsteil auf den Leiterplatten dient eine Steckverbindung 142, 143. Der Stecker 142 sitzt am Rückteil 119; der Stecker 143 ist auf der Leitplatte 120 angeordnet. Im montierten Zustand kann das gesamte Gebilde der Figur 8 in das hochisolierende Mantelgehäuse 94 des Einschubes von der Frontseite her eingeschoben werden. Es entsteht somit ein Einschub, wie er in der Figur 5 dargestellt ist.

Die Figur 9 zeigt im Ausschnitt eine Koppelstelle für Energieübertragung, wie sie sich darstellt, wenn ein Einschub in seine Endstellung im Isoliergehäuse gebracht ist. Mit 98 ist demnach in gebrochener und geschnittener Darstellung wieder die Rückwand des Einschubgehäuses 94 mit Materialverdünnung 99 im Zentrum dargestellt. Die Materialverdünnung 99 ist auch noch mit einem Zentrierkreuz 144 versehen. Mit 145 ist der Koppelgliedträger bezeichnet. Dieser Träger trägt den schon in der Figur 8 dargestellten einschubseitigen Schalenkern 137 zur Aufnahme des sekundärseitigen Spulenkörpers. Der Schalenkern 137 ist geschlitzt; durch den Schlitz 146 sind gleichzeitig die Anschlussdrähte für den Spulenkern geführt. Der Übertragerträger samt Schalenkern und Spulenkörper ist mittels Haltenippel 147 unter Einschluss einer Feder 148 am Rückteil 119 federnd aufgehängt. Ein Sicherungsring 149 sichert die Anordnung gegen Herausfallen.

Eine ähnliche Bauweise bietet auch die Aufhängung des Koppelgliedes auf der Seite des Gerätes, Mit 57 ist wieder die Rückplatte des Isoliergehäuses 13 dargestellt. Die Rückplatte 57 trägt entsprechend Figur 3. z.B. den Montagezylinder 62 mit Schulter 64 und Zentriersteg 65 der Stegverdünnung des Oberrandes. Auf dem so gestalteten Oberrand des Aufnahmezylinders 62 sitzt die Montageplatte 151 für einen geräteseitigen Koppelgliedträger 152 mit montiertem Schalenkern 153 mit Schlitz 154 für den geräteseitigen Spulenkörper. Der Koppelgliedträger ist wieder mittels Haltenippel 155 und Feder 156 sowie Sicherungsring 157 schwimmend an der Montageplatte 151 aufgehängt. Träger der Montageplatte 151 ist eine Leiterplatte 159, die die für Energie- und Signalübertragung nötigen elektronischen Bauelemente trägt. Zur Befestigung der Montageplatte auf der Leiterplatte dient ein Schnappnippel 158, der in die Leitplatte einfach eingeschnappt wird. Zur Sicherung gegen Verdrehung dient zwischen Übertragerträger und Montageplatte wieder ein Montagestift 160 und zwischen Montageplatte und Leiterplatte ein Stift 161, während 162 eine sehr dünne Dichtfolie ist, die über die Innenfläche der Rückplatte 57 gespannt ist.

Mit der Erfindung wird also nicht nur erreicht, dass auch bei grossvolumiger bzw. grossflächiger Ausbildung der Einsteckverbindung Koppelkapazitäten zwischen Metallteilen im Inneren der Einschübe und Metallteilen im Inneren des Gerätegehäuses so klein wie möglich gehalten werden, so dass auch der Ableitstrom vernachlässigbar klein wird; durch die besondere Formgebung des Isolierkörpers und durch dessen besonders funktionsgerechten Zusammenbau mit weiteren Bauteilen, wie z.B. Auswerfmechanismus in Verbindung mit Arretiervorrichtung, bauliche Zuordnung der Einzelbestandteile jeder Koppelstelle zueinander etc., ist darüber hinaus ein Gerät geschaffen, das im Sinne der Erfindung optimal und platzsparend einsetzbar ist.

**Patentansprüche**

1. Galvanisch trennende Koppelstelle für Energie- und/oder Signalübertragung, mit Primär- und Sekundärkoppelgliedern, von denen eines jeweils in einer Einbuchtung eines ersten Gehäuses angeordnet ist und das andere in einem zweiten Gehäuse sitzt, das als Steckteil in die Einbuchtung des ersten Gehäuses einschiebbar ist, wobei die Koppelglieder zueinander passende Ankoppelflächen aufweisen, über die durch Zusammenfügen bei Herstellen der Steckverbindung die Koppelstelle hergestellt wird, dadurch gezeichnet, dass wenigstens eines der Koppelglieder (137, 145, 146 bzw. 152, 153, 154), vorzugsweise jedoch beide, mittels Haltenippel (147 bzw. 155) unter Zwischenlagerung einer Feder (148 bzw. 156) an einer Wand des jeweiligen Gehäuses (13 bzw. 15 bis 18) oder an einem im jeweiligen Gehäuse anzuordnenden Koppelteil-Träger (119 bzw. 151) schwimmend und federnd aufgehängt ist, wobei der jeweilige Haltenippel (147 bzw. 155) an der Gehäusewand oder am Trägerteil im Gehäuse mittels Sicherungsring (149 bzw. 157) eingehängt ist.

2. Koppelstelle nach Anspruch 1, dadurch gezeichnet, dass nur das primäre und/oder das zugeordnete sekundäre Koppelglied (137, 145, 146 bzw. 152, 153, 154) eines Energieübertragers, schwimmend und federnd aufgehängt sind.

3. Koppelstelle nach Anspruch 1 oder 2, dadurch gezeichnet, dass die Koppelglieder mittels eines Koppelglied-Trägers (145 bzw. 152) mit aufmontiertem Schalenkern (137 bzw. 153) für einen Spulenkörper an der Gehäusewand oder an einem Trägerteil im Gehäuse schwimmend und federnd aufgehängt sind und dass der auf dem Übertragerträger (145 bzw. 152) montierte Schalenkern (137 bzw. 153) geschlitzt ist, wobei der jeweilige Schlitz (146 bzw. 154) gleichzeitig als Leitungszuführung zum im jeweiligen Schalenkern positionierten Spulenkörper dient.

4. Koppelstelle nach Anspruch 3, dadurch gezeichnet, dass die Einbuchtung im Gerätegehäuse (1) etagenmässig unterteilt ist und dass in jede der Etagen ein Geräteeinschub (15 bis 18) als Signalübertragungsteil einschiebbar ist, und dass für jeden Einschub in jeder Etage wenigstens eine Energiekoppelstelle vorhanden ist, von der das eine Koppelglied an einer Wand, vorzugsweise Rückwand (98), des jeweiligen Einschubes und das dazu passende zweite Koppelglied an entsprechender Stelle einer Wand, vorzugsweise ebenfalls Rückwand (57), der Geräteeinbuchtung (13) sitzt und dass jeder Geräteeinschub (15 bis 18) an jener Wand (98), die eine isolierte Trennwand zwischen einem Sekundärkoppelglied (137, 145, 146) auf der Seite des Einschubes und dem dazu passenden Primärkoppelglied (152, 153, 154) auf der Seite der Geräteeinbuchtung (13) bildet, über eine Fläche (99), die in etwa der Fläche eines Übertragerhalbteiles entspricht, im Material verdünnt ist (z.B. ≤1 mm), um den Abstand an der Übertragungsstelle klein und damit die Energieverluste gering zu halten, und dass die materialverdünnte Fläche (99) auch noch mit wenigstens einem Zentrierstift, insbesondere Zentrierkreuz (144) im Zentrum der Fläche, versehen ist, der zu einer Zentrieröffnung im an der Fläche anzukoppelnden Energieübertrager passt.

5. Koppelstelle nach einem der Ansprüche 1 bis 4, dadurch gezeichnet, dass die Einbuchtung im Gerätegehäuse (1) etagenmässig unterteilt ist und dass in jede der Etagen ein Geräteeinschub (15 bis 18) als Signalübertragungsteil einschiebbar ist, der ein Mantelgehäuse (94) aus hochisolierendem Material umfasst, in welches Mantelgehäuse von der Frontseite her ein metallisch abgeschirmter Leiterplattenaufbau (Figur 8) einschiebbar ist, der an der Rückseite ein Rückteil (119) trägt, an dem das einschubseitige Sekundärkoppelglied (137 etc.) des Energieübertragers schwimmend und federnd aufgehängt ist.

6. Koppelstelle nach einem der Ansprüche 1 bis 5, dadurch gezeichnet, dass zur Montage der primären Koppelglieder (152, 153, 154) auf der Seite des Gerätes die Rückwand (57) der Gehäuseeinbuchtung (13) Aufnahmeräume, insbesondere Montagezylinder (62, 63 etc.), für die Energieübertragerkoppelglieder umfasst.

7. Koppelstelle nach Anspruch 6, dadurch gezeichnet, dass die Aufnahmeräume (62, 63) an dem der Rückplatte abgewandten Rand stegartig verdünnt sind und dass die jeweilige Schulter (64) der Stegverdünnung des Oberrandes als Auflage für eine Montageplatte (151) dient, die durch den eigentlichen Oberrandrundsteg (65) auch noch zentriert wird und an der das jeweilige Primärkoppelglied (152, 153, 154) schwimmend und federnd aufgehängt ist.

8. Koppelstelle nach Anspruch 7, dadurch gezeichnet, dass die Montageplatte (151) wiederum von einer Leiterplatte (159) getragen ist, die an der Rückfläche (57) der Geräteeinbuchtung (13) montierbar, insbesondere anschraubbar, ist und auf der die für Energie- und Signalübertragung erforderlichen elektronischen Bauelemente montiert sind, welche die Montageplatte (151) mittels Schnappnippel (158) an der Leitplatte (159) befestigt ist.

9. Koppelstelle nach Anspruch 7 oder 8, dadurch gezeichnet, dass zur Verhinderung einer Verdrehung zwischen Montageplatte (151) und Primärkoppelglied (152, 153, 154) zwischen diesen beiden Bauteilen ein erster Montagestift (160) eingreift und zur Sicherung gegen Verdrehung zwischen Montageplatte (151) und Leiterplatte (159) zwischen letzteren beiden Bauteilen ein zweiter Montagestift (161) eingreift.

**Claims**

1. An electrically isolating coupling point for energy-and/or signal transfer, with primary and secondary coupling elements, one of which is in each case arranged in a recess in a first housing and the other of which is located in a second housing which can be inserted as a plug-in component into the recess in the first housing, where the coupling elements exhibit coupling surfaces which match one another and form the coupling point during assembly to establish the plug-in connection, characterized in that at least one of the coupling elements (137, 145, 146 or 152, 153, 154), and preferably both, is freely suspended in elastically movable fashion by support nipples (147 or 155) with interposed springs (148 or 156) on a wall of the particular housing (13 or 15 to 18) or on a coupling component carrier (119 or 151) arranged in the housing in question, where the particular support nipple (147 or 155) is suspended on the housing wall or on the carrier component in the housing by means of a retaining ring (149 or 157).

2. A coupling point as claimed in Claim 1, characterized in that only the primary and/or the assigned secondary coupling element (137, 145, 146 or 152, 153, 154) of an energy transformer are suspended in floating and elastic fashion.

3. A coupling point as claimed in Claim 1 or 2, characterized in that the coupling elements are suspended in floating and elastic fashion by means of a coupling element carrier (145 or 152) upon which is mounted a shell-type core (137 or 153) for a coil body on the housing wall or on a carrier component in the housing, and that the shell-type core (137 or 153) which is mounted on the transformer carrier (145 or 152) is slotted, where the slot (146 or 154) serves simultaneously as a supply line guide to the coil body positioned in the shell-type core in question.

4. A coupling point as claimed in Claim 3, characterized in that the recess in the device housing (1) is sub-divided into levels, and that a device slide-in unit (15 to 18) can be inserted as signal transfer component into each of the levels, and that for each slide-in unit in each level there is provided at least one energy coupling point in respect of which the first coupling element is positioned on a wall, preferably the rear wall (98) of the slide-in unit in question, and the matching second coupling element is positioned at a corresponding location on a wall, preferably likewise the rear wall (57) of the device slide-in unit (13), and that on that wall (98) which forms an isolated partition wall between a secondary coupling element (137, 145, 146) on one side of the slide-in unit and the matching primary coupling element (152, 153, 154) on the side of the device recess (13), the material of each device slide-in unit (15 to 18) being reduced in thickness (e.g. $\leq$ 1 mm), over a surface (99) corresponding approximately to the surface of half the transformer, in order to minimise the spacing at the transfer point and thus teh energy losses, and that the surface (99) which has been reduced in thickness is also provided with at least one centering pin, in particular a centering cross (144) in the centre of the surface, which pin matches a centering opening in the energy transformer which is to be coupled to the surface.

5. A coupling point as claimed in one of the Claims 1 to 4, characterized in that the recess in the device housing (1) is sub-divided into levels, and that a device slide-in unit (15 to 18) can be inserted into each of the levels by way of signal transfer component and includes a casing housing (94) consisting of highly insulating material into which housing there can be inserted from the front end a metallically screened circuit board structure (figure 8) which bears at its rear a rear component (119) from which the secondary coupling element (137 etc.) of the energy transformer located on the slide-in unit side is suspended in floating and elastic fashion.

6. A coupling point as claimed in one of the Claims 1 to 5, characterized in that for the assembly of the primary coupling elements (152, 153, 154) on the side of the device the rear wall (157) of the housing recess (13) exhibits receiving cavities, in particular assembly cylinders (62, 63 etc), for the energy transformer coupling elements.

7. A coupling point as claimed in Claim 6, characterized in that the receiving cavities (62, 63) are reduced in thickness in flange-like fashion at the edge facing away from the rear plate, and that the particular shoulder (64) of the flange thus formed at its upper edge serves as a bearing for a mounting plate (151) which is aditionally centered by the actual circular flange (65) of the upper edge and from which the primary coupling element (152, 153, 154) is suspended in floating and elastic fashion.

8. A coupling point as claimed in Claim 7, characterized in that the assembly plate (151) is in turn supported by a circuit-board (159) which can be mounted, particularly screwed, onto the rear surface (57) of the device recess (13), and on which are mounted the electronic components which are required for the energy and signal transfer, which mounting plate (151) is attached to the circuit-board (159) by means of snap nipples (158).

9. A coupling point as claimed in Claim 7 or 8, characterized in that in order to prevent rotation between mounting plate (151) and primary coupling element (152, 153, 154), a first assembly pin (160) engages between these two components and in order to prevent rotation between mounting plate (151) and circuit-board (159) a second assembly pin (161) engages between the two latter components.

**Revendications**

1. Connecteur à découplage galvanique pour la transmission d'énergie et/ou de signaux, comportant des éléments de couplage primaire et secondaire dont l'un est disposé dans une cuvette d'un premier boîtier et dont l'autre est monté dans un second boîtier qui est susceptible d'être inséré, à la manière d'un élément enfichable, dans la cuvette du premier boîtier, les éléments de couplage présentant des surfaces de couplage s'adaptant entre elles et par l'intermédiare desquelles le connecteur est réalisé par l'assemblage pour l'établissement de la liaison par enfichage, caractérisé par le fait qu'au moins l'un des éléments de couplage (137, 145, 146 ou 152, 153, 154), mais de préférence les deux sont, à l'aide de nipples de maintien (147 ou 155) et avec interposition d'un ressort (148 ou 156), suspendus de façon flottante et élastique sur une paroi du boîtier correspondant (13 ou 15 à 18) ou sur un support d'élément de couplage (119 ou 151) à disposer dans le boîtier correspondant, le nipple de maintien concerné (147 ou 15) étant accroché à la paroi de boîtier ou à l'élément de support dans le boîtier à l'aide d'un circlip (149 ou 157).

2. Connecteur selon la revendication 1, caractérisé par le fait que seul l'élement de couplage primaire et/ou secondaire (137, 145, 146 ou 152, 153, 154) d'un transformateur d'énergie est suspendu de façon flottante et élastique.

3. Connecteur selon la revendication 1 ou 2, caractérisé par le fait que les éléments de couplage sont suspendus de façon flottante et élastique sur la paroi de boîtier ou sur un élément de support dans le boîtier à l'aide d'un support d'élément de couplage (145 ou 152) à noyau de coquille monté (137 ou 153) pour un corps de bobine, et que le noyau de coquille (137 ou 153) monté sur le support d'éléments de couplage (145 ou 152) est fendu, la fente (146 ou 154) servant de même temps de conducteur d'amenée pour le corps de bobine placé dans le noyau de coquille concerné.

4. Connecteur selon la revendication 3, caractérisé par le fait que la cuvette dans le boîtier d'appareil (1) est subdivisée en étages, et que dans chaque étage est insérable un tiroir d'appareillage (15 à 18) constituant un élément de transmission de signaux, et qu'il est prévu pour chaque tiroir dans chaque étage au moins un point de couplage d'énergie dont un élément de couplage est monté sur une paroi, de préférence la paroi postérieure (98) du tiroir concerné et dont le second élément de couplage, adapté au premier, est monté en un emplacement correspondant d'une paroi, de préférence également la paroi postérieure (57) de la cuvette de l'apareil (13), et que le matériau de chaque tiroir d'appareillage (15 à 18) est aminci (par exemple ⩽ 1 mm) au niveau de la paroi (98) qui forme une paroi de séparation isolée entre un élément de couplage secondaire (137, 145, 146) sur un côté du tiroir et l'élément de couplage primaire qui lui correspond (152, 153, 154) sur l'autre côté de la cuvette d'appareil (13), par l'intermédiaire d'une surface (99) qui correspond sensiblement à la surface d'un demi-élément de transmission afin de maintenir à une faible valeur la distance au niveau du point de transmission et, par conséquent, les pertes d'énergie, et que la surface (99) amincie du point de vue du matériau est en outre pourvue d'au moins une cheville de centrage, en particulier d'un croisillon de centrage (144) au centre de la surface, qui s'adapte à une ouverture de centrage ménagée dans le transformateur d'énergie à accoupler à la surface.

5. Connecteur selon l'une des revendications 1 à 4, caractérisé par le fait que la cuvette dans le boîtier d'appareil (1) est subdivisée en étages et que dans chacun des étages est susceptible d'être inséré un tiroir d'appareillage (15 à 18) en tant qu'élément de transmission des signaux, qui comporte une enveloppe (94) faite avec un matériau fortement isolant, enveloppe dans laquelle est susceptible d'être insérée, à partir du côté frontal, une structure à cartes imprimées (figure 8), à blindage métallique, structure qui porte sur sa face postérieure un élément postérieur (119) auquel est suspendu, de façon flottante et élastique l'élément de couplage secondaire (137, etc.) du transformateur d'énergie, qui est situe du côté de l'insertion.

6. Connecteur selon l'une des revendications 1 à 5, caractérisé par le fait que pour le montage des éléments de couplage primaires (152, 153, 154) sur le côté de l'appareil, la paroi postérieure (57) de la cuvette d'appareil (13), comporte des espaces de réception, en particulier des cylindres de montage (62, 63, etc.) pour les éléments de couplage de transmission d'énergie.

7. Connecteur selon la revendication 6, caractérisé par le fait que les espaces de réception (62, 63) situés sur le bord qui est éloigné de la plaque postérieure, sont amincis à la manière de paliers, et que l'épaulement concerné (64) de l'amincissement en forme de palier du bord supérieur sert d'appui pour une plaque de montage (151) qui est encore cintree par la collerette proprement dite du bord supérieur (65), et à laquelle est suspendu, de façon flottante et élastique, l'organe de couplage primaire correspondant (152, 153, 154).

8. Connecteur selon la revendication 7, caractérisé par le fait que la plaque de montage (151) est à son tour portée par une carte imprimée (159) qui est susceptible d'être montée, en particulier susceptible d'être vissée sur la face postérieure (57) de la cuvette d'appareil (13), et sur laquelle sont montés les composants électroniques qui sont nécessaires pour la transmission de l'énergie et des signaux et qui fixent la plaque de montage (151) à la carte imprimée (159), à l'aide de nipples à encliquetage (158).

9. Connecteur selon la revendication 7 ou 8, caractérisé par le fait que pour empêcher un décalage angulaire entre la plaque de montage (151) et l'élément de couplage primaire (152, 153, 154), une première cheville de montage (160) pénètre entre ces deux éléments constitutifs et que pour une sécurité contre un décalage angulaire entre la plaque de montage (151) et la carte imprimé (159), une seconde cheville de montage (161) pénètre entre ces deux derniers éléments constitutifs.

FIG 1

FIG 2

FIG 3

FIG 4

FIG 5

FIG 6

FIG 7

FIG 9

FIG 8